# EUROPEAN PATENT SPECIFICATION

(11) **EP 0 552 382 B1**
(45) Date of publication and mention of the grant of the patent: **19.11.1997**
(21) Application number: 92917862.2
(22) Date of filing: 12.08.1992
(51) Int. Cl.: G03F 7/11, G03F 7/26, H01L 21/027, G03F 7/09

(54) **A TWO LAYER STRUCTURERESIST AND A PROCESS FOR PRODUCING IT**
ZWEILAGENPHOTORESISTSTRUKTUR UND VERFAHREN ZU IHRER HERSTELLUNG
PHOTORESERVE A DEUX COUCHES ET PROCEDE POUR SA FABRICATION

(30) Priority: 13.08.1991 JP 202686/91
(43) Date of publication of application: 28.07.1993
(73) Proprietor: TORAY INDUSTRIES, INC., Tokyo 103 (JP)
(72) Inventor: TSUKAMOTO, Jun, Otsu-shi Shiga 520 (JP); ICHIJO, Chikara, Otsu-shi Shiga 520 (JP); IMAZU, Emi, Otsu-shi Shiga 520-21 (JP)
(74) Representative: Coleiro, Raymond
(86) International application number: JP9201031
(87) International publication number: WO9304406

(56) References cited:
- EP-A- 0 075 454
- EP-A- 0 164 750
- EP-A- 0 364 368
- EP-A- 0 449 439
- JP-A- 1 044 927
- JP-A- 2 007 053
- JP-A-56 042 229
- JP-A-58 066 938
- JP-A-61 013 245
- JP-A-62 108 244
- JP-A-63 155 044
- Section Ch, Week 8648, Derwent Publications Ltd., London, GB; Class A26, AN 86-314211 & JP-A-61 231 011 (AGENCY OF IND. SCI. & TECHN.) 15 October 1986
- Database INSPEC, Inst. of Electr. Engrs., London, GB. J.D TARGOVE et al : "Plasma Activated Chemical Vapour Deposition of Polythiophene Thin Films" INSPEC Nr. 4437856

## Description

The present invention relates to a method of forming on a substrate a patterned resist which comprises two-layer structure resist and to the use when producing or applying it of a thin film as an antireflective coating. In particular, it relates to the formation and application of a two-layer structure radiation-sensitive resist with a photosensitive resist layer and a thin film excellent in light interceptability, reflection preventiveness and film uniformity to give a fine resist pattern stable in processability.

Semiconductors are known in which conjugated polymers are used for assisting interconnection by, for example, doping of such layers to provide regions of different conductivity (see EP-A-0075454), or in which conjugated polymers serve to dissipate electrical charge when an adjacent electron beam resist layer is exposed to the pattern of an electron beam; see EP-A-0364368 and also EP-A-0449439 acknowledged under Art 54(3) EPC. A method of forming such a conjugated polymer on a substrate by plasma polymerization is described in JP-A-61-231011.

The manufacture of semiconductors keeps requiring finer processing techniques while semiconductors grow larger in capacity. The fine processing generally uses lithography.

General lithography is described below. A radiation-sensitive resist film is formed on a semiconductor substrate, and selectively irradiated with radiation to obtain a desired resist pattern, which is then developed, to form a resist pattern. With the resist pattern used as a mask, any action of etching, ion implantation, vapor deposition, etc. is repeated to prepare a semiconductor.

Resist patterns of about 0.5 µm are now industrially practically applied, but are required to be even finer. As one of the techniques for obtaining a finer resist pattern, a master drawing is projected in a reduced size using light with one wavelength as the radiation, for pattern exposure. Especially for finer processing, the light is required to be shorter in wavelength, and already a technique of irradiating with a wavelength of 436 nm is established. Furthermore, techniques of irradiating with light of 365 nm in wavelength or even light of far ultraviolet region of 300 nm or less in wavelength are being examined for development.

Lithography as described above has associated with it the following problems. First of all, reflection from the substrate causes interference of radiation in the radiation-sensitive resist film, and as a result, variation in the thickness of the radiation-sensitive resist causes the radiation energy applied to the radiation-sensitive resist film to be varied. In other words, a slight variation in the thickness of the radiation-sensitive resist is liable to cause the resist pattern obtained to be varied dimensionally. Furthermore, the wavelength of radiation shortened for finer processing generally increases the radiation reflection from the substrate, to make the variation more remarkable. The variation in the thickness of the resist layer is caused by variation in the properties of the radiation sensitive resist material over time and from lot to lot, the variation in the coating conditions of radiation-sensitive resist and also the steps formed on the substrate, if any. The dimensional variation of the resist pattern due to the variation in the thickness of the resist layer requires severe process tolerances during production which constitutes an obstacle to finer processing.

Furthermore, if the substrate is highly reflective and has steps complicatedly arranged, radiation is irregularly reflected, and is liable to locally change the desired resist pattern.

To solve these problems, methods for inhibiting the reflection from the substrate have been proposed. For example, an anti-reflection layer is formed by vapor-depositing a less reflective inorganic compound on the substrate, for lithographing. However, the inorganic compound makes film removal difficult and the method is limited in application since it is feared that if the method is applied during semiconductor production, the semiconductivity may be adversely affected.

EP-A-0164750 discloses a semiconductor device comprising (a) a silicon wafer comprising at least one semiconductor element and a layer of non-conductor on one of its surfaces, (b) an antireflective thin layer comprising a polyphenylquinoxaline and (c) a photoresist layer comprising a material whose solubility characteristics in certain solvents is affected by exposure to UV radiation. However, the antireflective layer is operable only for UV light having a wavelength from about 500 to 350 nm.

Moreover, for example, according to the method disclosed in JP-A-88-138353, a two-layer structure resist consisting of a radiation-sensitive resist as an upper layer, and a reflection preventive organic film soluble in the developer of the upper radiation-sensitive resist layer as a lower layer is formed, and after completion of irradiation, a pattern is formed in the upper layer by development while the lower layer is also developed through the opening of the pattern of the upper layer acting as a mask, to obtain a resist pattern. In this case, since the upper layer and the lower layer are generally different in their rate of dissolution into the developing solution, the resist pattern obtained is liable to be excessively or insufficiently processed in the lower layer because of the resultant difficulty in process control.

As described above, the use of a finer substrate in lithography brings with it the problem that the reflection of the substrate is liable to cause the produced resist pattern to deviate dimensionally from the desired pattern, and thus lower the yield of semiconductors.

The object of the present invention is to provide a two-layer structure resist with a thin film excellent in reflection preventiveness, light interceptability, for giving a fine resist pattern stable in processability and a process for producing it.

Thus, according to one aspect, the present invention provides the use in the formation of a resist pattern on a substrate by photolithography, of a thin film, mainly composed of a conjugate polymer, as an antireflective coating. The thin film serves as an antireflective coating during production, by photolithography, of a patterned resist containing the said thin film. Alternatively or additionally, the thin film, mainly composed of the conjugate polymer, may form part of a patterned resist comprising the said thin film and a layer formed from a photosensitive composition, the patterned resist being used as a mask during formation by lithography, of a pattern on a substrate, the thin layer serving, during the lithography, as an antireflective coating.

According to another aspect, the invention provides a method of forming on a substrate a patterned resist, which patterned resist comprises a two layer structure, which two layers are (1) a thin film mainly composed of a conjugated polymer and (2) a photosensitive resist layer respectively, which method comprises the steps of
(a) forming on the substrate the said thin film layer (1),
(b) forming on the said thin film layer (1) the photosensitive resist layer (2),
(c) exposing a selected part of the photosensitive resist layer (2) to UV light, leaving a part unexposed,
(d) removing unexposed part of the photosensitive resist layer (2) with a solvent, and
(e) removing part of the said thin film layer (1) thus exposed by etching.

An apparatus suitable for preparing a thin film for use in accordance with the present invention which forms a thin polymer film on a substrate by chemical vapor phase method comprises
(A) a means for gasifying a catalyst and letting the gasified catalyst be adsorbed by the surface of the substrate, and
(B) a means for bringing the substrate with the catalyst adsorbed into contact with a monomer gas, for forming a thin polymer film on the surface of the substrate.

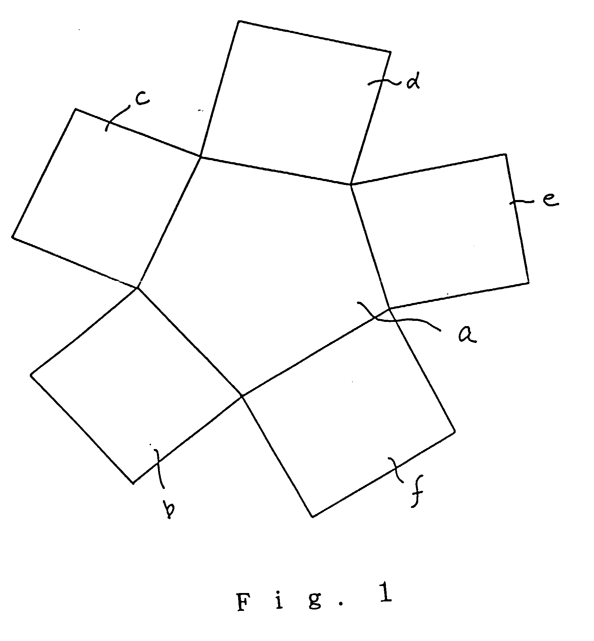

Fig. 1 is a schematic drawing showing the thin film making apparatus suitable for preparing a thin film of the present invention, viewed from above.

The substrate may be colored depending upon the required light transmission. The material can be selected, for example, from glass, polymers, thin transparent metal films, silicon oxide, etc. It is preferably selected from the materials used in lithography. The present invention exhibits its effect especially in the production of semiconductor integrated circuits. In this case, it can be selected, for example, from semiconducting bases such as silicon, germanium, gallium compounds and indium compounds, and furthermore, these bases with a pattern formed by impurity diffusion, nitride, oxide, insulating layer, conductive layer or wiring, etc. Moreover, the present invention is effective also for preparing photomasks, and flat panel displays, for example, by forming a metal or thin film semiconductor, etc. on a transparent base such as glass.

The conjugated polymer used to form the thin film can be selected, for example, from polyacetylene, polypyrrole, polythiophene, polyphenylenevinylene, polythiophenevinylene, their derivatives, etc., more desirably, alkylated polypyrroles and alkylated polythiophenes soluble in solvents obtained by substituting said conjugated polymers by alkyl groups or alkoxy groups, and polyphenylenevinylene and polythiophenevinylene synthesized through soluble intermediate products. Above all, acetylene polymer or a substituted acetylene polymer is preferable. The substituted acetylene polymer can be selected from polycyanoacetylene, polymethylacetylene, polyphenylacetylene, polyfluoroacetylene, polybutylacetylene, polymethylphenylacetylene, etc. The most preferable conjugated polymers are polyacetylene, polycyanoacetylene, polyfluoroacetylene and polymethylphenylacetylene.

The thin film can be formed on the substrate by dissolving the conjugated polymer and/or a precursor product into a predetermined solvent, and applying the solution onto the substrate by spin coating or by synthesizing the conjugated polymer and/or its intermediate product from the corresponding monomer directly on the substrate.

The former polymerization method can be optionally selected from conventional methods. For example, an alkylated polyacetylene soluble in tetrahydrofuran is synthesized by the ring opening metathesis polymerization of the corresponding alkyl cyclooctatetraene, and its solution is applied. As a method of using an intermediate product, 7,8-bis(trifluoromethyl)tricyclo[4,2,2,0^{2.5}]deca-3,7,9-triene synthesized from hexafluoro-2-butene and cyclooctatetraene is used as a starting raw material and polymerized in toluene using tungsten hexachloride and tetraphenyltin as catalysts, to synthesize a polymer soluble in acetone and chloroform, and the solution is applied onto the substrate, for subsequent formation of a thin polyacetylene film by decomposition reaction. Furthermore, a thin polyacetylene film can be obtained by a reaction removing hydrochloric acid from a thin polyvinyl chloride film formed by spin coating.

On the other hand, the formation of the thin film on the substrate by direct synthesis as the latter method can be achieved by polymerizing a monomer capable of forming the conjugated polymer, directly on the substrate by plasma polymerization, catalyst reaction, thermal reaction or light reaction, etc. For example, a thin film of polyacetylene or polyfluoroacetylene, etc. is formed on the substrate by plasma polymerization, or a thin film of polyacetylene or polycyanoacetylene is formed on the substrate using a catalyst.

These conjugated polymers are excellent in reflection preventive effect, photo shading effect and film formability, and because they are organic compounds, they allow easy pattern processing by etching.

Moreover, to improve the chemical properties of these thin films, heat treatment may be optionally applied after formation of such thin films.

The light transmittance of the thin film depends on the wavelength of the light used for the intended application, but should be preferably 5% or less, more preferably 1% or less for the light used. For example, for a master drawing for lithography, the transmittance should be preferably as stated above for the light used for forming the pattern. For a color for liquid crystal display or image sensor, the transmittance should be preferably as stated above in a wavelength range from 400 to 600 nm.

The reflectance of the thin film depends on the wavelength of the light used for the intended application, and should be preferably 50% or less, more preferably 30% or less, further more preferably 20% or less in air to the light used. For example, for a master drawing for photolithography, the reflectance should be preferably as stated above to the light used for forming the pattern, and for a color filter or image sensor for liquid crystal display, the reflectance should be preferably as stated above in a wavelength range from 400 to 600 nm.

The method according to the invention for forming a pattern using the two-layer structure resist is described below with reference to an embodiment. The thin film is formed on the substrate. On the thin film, an upper resist layer capable of forming a pattern in response to light is formed, to make a two-layer structure resist. Then, it is irradiated with light for forming the pattern, and developed, to form the pattern of the upper resist layer. Subsequently, with the upper resist layer as a mask, the lower resist layer is removed in the portion corresponding to the opening of the upper resist layer by dry etching, to form the pattern of the two-layer structure resist.

In this case, the wavelength of light for forming the pattern can be optionally selected within lithography technology, but among the light, especially electromagnetic waves with a wavelength of 150 nm or more are effective for the lower resist layer of the present invention. For example, a mercury lamp line of about 436 nm, about 405 nm, about 365 nm or about 254 nm, etc. in wavelength or a laser beam of about 364 nm, about 248 nm or about 193 nm can be used.

The thin film used in accordance with the present invention may be used later as an etching resistant mask, as described above, and so should be preferably high in carbon content in view of etching resistance. The lower resist layer should be preferably 30% or more, more preferably 50% or more in the number of carbon atoms based on the total number of atoms. The thickness of the lower resist film is optional. However, if it is too thin, its anti-reflection effect is too low and its ability to cover the substrate is insufficient. If too thick, the resist pattern of the two-layer structure finally obtained is poor in resolution. So, the thickness should be preferably 0.01 to 10 µm, more preferably 0.02 to 5 µm.

The resist used as the upper layer can be selected from any photosensitive resists capable of forming a pattern by light irradiation and development, preferably from those sensitive to the electromagnetic waves with any wavelength stated above as light used for irradiation. For example, it can be selected from photosensitive resists containing a quinonediazide compound, naphthoquinonediazide compound, azide compound or bisazide compound, etc. as a photosensitive component, chemical amplification photosensitive resists consisting of a compound generating an acid by light irradiation and a compound changed in molecular weight or converted in functional group by the acid, and photosensitive resists composed of a compound increased or decreased in molecular weight or caused to react in its functional group by light irradiation. The upper resist layer can be generally applied by spin coating of a solution with any of said photosensitive compounds dissolved in a predetermined solvent.

In a process embodying the present invention, an intermediate layer can be optionally formed for any of various purposes between the lower resist layer and the upper resist layer.

The known of the present invention may preferably utilize a thin film making apparatus for forming a thin polymer film on a substrate by chemical vapor phase method, comprising
(A) a means for gasifying a catalyst and causing the gasified catalyst to be adsorbed by the surface of the substrate, and
(B) a means for bringing the substrate with the catalyst adsorbed into a monomer gas, for forming a thin polymer film on the surface of the substrate.

The respective means are described below in detail.

The method (A) for gasifying a catalyst and causing the gasified catalyst to be adsorbed by the surface of a substrate can be effected under reduced pressure or at atmospheric pressure. If the catalyst gas is introduced into a reactor c (Fig. 1) in which the substrate is placed, and allowed to stand for a predetermined time, the catalyst gas can be adsorbed by the surface of the substrate. The standing time depends on the substrate temperature and the catalyst used, but should be preferably from 30 seconds to 10 minutes. The substrate temperature should be preferably as low as possible above the freezing point of the catalyst gas, since the catalyst can be adsorbed by the substrate quickly. Furthermore, since the amount of the catalyst adsorbed depends on the substrate temperature, the thickness of the thin film to be formed can be controlled by changing the temperature. The catalyst can be optionally selected from those known to allow the polymerization of the monomer concerned, but when it is used for a semiconductor, a compound without any metal atom is preferable considering the adverse effect on semiconductivity. In view of film forming rate, the catalyst can be preferably selected from amine compounds, especially amine compounds with a tertiary amino group. The amine compounds with a tertiary amino group include, for example, triethylamine, tripropylamine, tributylamine, hexamethylethylenediamine pyridine, 4-dimethylaminopyridine, triethylenediamine, N,N-dimethylaminoethanol, etc.

The catalyst gas can be introduced into the reactor preferably alone or together with an inert gas. The inert gas can be preferably selected from argon gas and nitrogen gas.

The step (B) of bringing the substrate with the catalyst adsorbed into contact with a monomer gas for forming a thin polymer film on the surface of the substrate can be effected by placing the substrate with the catalyst adsorbed in a reactor d (Fig. 1) and bringing it into contact with a monomer gas for polymerization reaction of the monomer on the surface of the substrate.

The polymerization temperature should be desirably as low as possible above the solidifying point of the catalyst gas. The polymerization can be effected under reduced pressure or at atmospheric pressure. The monomer gas can be introduced into the reactor c preferably alone or together with an inert gas. The inert gas can be preferably selected from argon gas and nitrogen gas. The polymerization time depends on the monomer concentration, substrate temperature and the monomer used, but should be preferably 30 seconds to 20 minutes.

### Example 1

Nitrogen gas was blown into cyanoacetylene as a monomer gas and triethylamine as a catalyst respectively with bubbling at respective rates of 500 ml/min and 100 ml/min, to make a mixed gas consisting of cyanoacetylene and triethylamine with nitrogen gas as a carrier gas, and the mixed gas was introduced into a reaction box containing quartz glass. A thin cyanoacetylene polymer film was formed on the quartz glass, for use as a photo shading film. On the light intercepting film, a film of electron beam-sensitive resist EBR-9, a substituted acrylate polymer produced by Toray Industries, Inc. was formed, irradiated with an electron beam and developed, to form a resist pattern opening of 5 mm in length and 1 mm in width. The light intercepting film in the portion corresponding to the opening of the electron beam-sensitive resist was removed by oxygen plasma, and the thin film of the electron beam-sensitive resist EBR-9-DR60 in the other portion than the opening was removed, to prepare a mask for lithography with a 0.2 µm thick light intercepting film formed on quartz glass. The reflectance of the photo shading film of cyanoacetylene polymer was measured by a spectrophotorecorder (U-3410) produced by Hitachi, Ltd. and found to be less than 5% in a wavelength range from 400 nm to 230 nm. The light transmittance of the light intercepting film was less than 3% in a wavelength range from 400 nm to 230 nm.

The obtained mask for lithography was installed in a 1/5 reduction exposure projector of 365 nm in light wavelength, NSR-1755i7A produced by Nikon Corp., and a silicon wafer coated with positive photoresist PR-alpha 2000 made of a naphthoquinone diazide compound produced by Toray Industries, Inc. was exposed. It was developed by a developer containing 2.4% of tetramethylammonium hydroxide, and the side wall angle of the photoresist pattern obtained was observed by an electron microscope and found to be 88 degrees.

### Example 2

Quartz glass similar to that used in Example 1 was placed in a plasma reactor, and fluoroacetylene gas as a monomer and argon gas as a carrier gas were fed into the reactor respectively at a rate of 5 ml/min. The internal pressure of the reactor was adjusted to be in a range from 6.7 to 40 Pa (0.05 to 0.3 torr). Subsequently, high frequency 12 W of 13 MHz was supplied to a coil electrode provided outside the reactor, for plasma polymerization, to form a thin fluoroacetylene polymer film.

The quartz glass with the thin fluoroacetylene film formed was coated with an electron beam-sensitive resist, exposed to an electron beam to form a resist pattern and etched by oxygen plasma as in Example 1, to prepare a mask for lithography with a photo shading film (0.3 µm thick) formed on the quartz glass.

The reflectance of the photo shading film formed on the mask was measured as in Example 1 and found to be less than 6% in a wavelength range from 400 to 230 nm. The light transmittance was less than 5% in a wavelength range from 400 to 230 nm.

The mask for lithography obtained was installed in the same scale-down exposure projector as that used in Example 1, and a photoresist pattern was formed. The side wall angle of the photoresist pattern obtained was observed and found to be 88 degrees.

### Example 3

Sixty millimoles of 7,8-bis(trifluoromethyl)tricyclo [4,2,2,0^{2.5}]deca-3,7,9-triene per liter was used as a starting raw material, and polymerized in toluene solution using 0.8 mmol/l of tungsten hexachloride and 1.6 mmol/l of tetraphenyltin as catalysts. The polymer was dissolved into acetone, and the solution was applied as in Example 1 and heat-treated at about 100°C, to form a thin polyacetylene film.

The quartz glass with the thin polyacetylene film formed was coated with an electron beam-sensitive resist, exposed to an electron beam to form a resist pattern and etched by oxygen plasma, as in Example 1, to prepare a mask for lithography with a light intercepting film (0.5 µm thick) formed on the quartz glass.

The reflectance of the light intercepting film formed on the mask was measured as in Example 1 and was found to be less than 7% in a wavelength range from 400 to 230 nm. The light transmittance was less than 3% in a wavelength range from 400 to 230 nm.

The mask for lithography obtained was installed in a scale-down exposure projector as in Example 1, and a photoresist pattern was formed. The side wall angle of the photoresist pattern obtained was observed and found to be 85 degrees.

### Comparative Example 1

Metal chromium was vapor-deposited onto the same quartz glass as used in the above Examples, to form a light intercepting film (0.1 µm thick). On the light intercepting film, a pattern of an electron beam-sensitive resist was formed and treated by plasma oxygen as in Example 1, to prepare a mask for lithography with the light intercepting film formed on the quartz glass. The reflectance of the light intercepting film formed on the mask was measured as in Example 1 and found to be 30 to 60% in a light wavelength range from 500 to 230 nm. The light transmittance was less than 0.1% in a range from 500 to 230 nm.

The mask for lithography obtained was installed in the same reduction exposure projector as that used in Example 1, and a photoresist pattern was formed. The side wall angle of the photoresist pattern was observed and found to be 82 degrees. Thus, the resist pattern was poorer than those obtained in Examples 1 to 3.

### Example 4

On a glass substrate, a light intercepting film (0.3 µm thick) made of cyanoacetylene polymer was formed as in Example 1. The photoshading film was coated with a naphthoquinone diazide compound, Photoresist PR-alpha 1000 produced by Toray Industries, Inc., and the photoresist was exposed to a pattern and developed, to form a photoresist pattern. Through the opening of the photoresist pattern, the photoshading film was etched by oxygen plasma, and the photoresist was removed, to form a black matrix pattern as a black, defectless and uniform photo shading film on the glass substrate.

The reflectance of the black matrix was measured as in Example 1, and found to be less than 5% in a wavelength range from 400 to 600 nm.

Three transparent paints colored blue, green and red respectively were sequentially formed in pattern by repeating photolithography and wet etching, to form blue, green and red color patterns, for preparing a color filter.

### Example 5

Nitrogen gas was blown into cyanoacetylene as a monomer gas and triethylamine as a catalyst at 25°C respectively at 500 ml/min and 100 ml/min with bubbling, to make a mixed gas consisting of cyanoacetylene and triethylamine with nitrogen gas as a carrier gas, and the mixed gas was introduced into a reaction box containing quartz glass. Vapor phase polymerization reaction of cyanoacetylene occurred, and a thin cyanoacetylene polymer film (0.1 µm thick) was formed on a silicon wafer, as a lower resist layer. The reflection of the substrate with the thin cyanoacetylene polymer film formed (12° in the angle of incidence) was measured using a spectrophotometer produced by Hitachi, Ltd. (U-3410) and found to be about 5% in a range from 500 to 230 nm.

On the substrate covered with the lower resist layer, Photoresist PR-alpha 2000 produced by Toray Industries, Inc. was applied by spin coating, and baked to form an upper resist layer. An i-line (light of 365 nm in wavelength) stepper produced by Nikon Corp. was used for exposure to a pattern, and development was effected using an aqueous solution containing 2.4% of tetramethylammonium hydroxide, to form an upper resist layer pattern.

With the upper resist layer pattern as a mask, the lower resist layer was anisotropically etched by oxygen plasma, to obtain an excellent two-layer structure resist pattern.

In further experiments, the thickness of the upper resist layer was changed between 1.0 µm and 1.2 µm in 0.02 µm steps, and the line width was measured with attention paid to the resist pattern lines obtained with a design line width of 1 µm. As a result, the difference between the maximum and minimum widths attributable to the change in the thickness of the upper resist layer was as little as 0.05 µm.

### Example 6

Tungsten hexachloride, water and tetraphenyltin as catalysts were added to carbon tetrachloride respectively at rates of 5.0 mmol/l, 2.5 mmol/l and 5.0 mmol/l with stirring in flowing nitrogen gas. The mixture was aged at room temperature for 10 minutes, and 1 mol/l of phenylacetylene was added to the catalyst solution. Polymerization was effected at room temperature for 1 hour, and methanol containing ammonia solution was added to stop polymerization, for obtaining a slurry polymer. It was filtered, and the residue was purified by toluene and methanol. The obtained polymer was dissolved into toluene, and the solution was applied onto a silicon wafer by spin coating, to form a thin polyphenylacetylene film on the substrate. A two-layer structure resist pattern was obtained as in Example 5, except that a thin polyphenylacetylene polymer film (0.2 µm) was formed as a lower resist layer. The dimensional variation depending on the thickness of the upper resist layer was measured, and as a result, the difference between the maximum and minimum values was found to be as little as 0.07 µm.

### Example 7

A silicon wafer was placed in a plasma reactor tube, and fluoroacetylene gas as a monomer and argon gas as a carrier gas were supplied with the internal pressure of the reactor tube kept in a range from 6.7 to 40 Pa (0.05 to 0.3 torr.) Subsequently, 13MHz of 12W radio wave was supplied to a coil electrode provided outside the reactor tube, for plasma polymerization, to form a thin fluoroacetylene polymer film (0.3 µm). An excellent two-layer structure resist pattern was obtained as in Present Example 5, except that the thin film was used as the lower resist layer. The reflectance was measured as in Example 1, and was found to be about 7% to the i line (light of 365 nm in wavelength). Furthermore, the dimensional variation based on the change in the thickness of the upper resist layer was measured as in Example 1, and as a result, the difference between the maximum and minimum values was found to be as little as 0.06 µm.

### Example 8

At first, 7,8-bis(trifluoromethyl)tricyclo[4,2,2, 0^{2.5}]deca-3,7,9-triene was synthesized from hexafluoro-2-butyne and cyclooctatetraene, for use as a starting raw material. It was polymerized in toluene solvent using tungsten hexachloride and tetraphenyltin as catalysts. The polymer was dissolved into acetone, and the solution was applied onto a substrate by spin coating. A decomposition reaction was then effected to form a thin polyacetylene film (0.3 µm thick). The reflectance was measured as in Example 5, and found to be about 6% to the i line (light to 365 nm in wavelength). Furthermore, upper resist layers were prepared as in Example 1, and the dimensional variation for different film thicknesses was measured. The difference between the maximum and minimum values was as little as 0.07 µm.

### Comparative Example 2

A silicon wafer was coated with Photoresist PR-alpha 2000 produced by Toray Industries, Inc. by spin coating, and baked at 110°C. An i line (light of 365 nm in wavelength) stepper produced by Nikon Corp. was used for pattern exposure, and development was effected using an aqueous solution containing 2.4% of tetramethylammonium hydroxide, for forming a resist pattern.

In further experiments, the thickness of the resist film was changed between 1.0 µm and 1.2 µm in 0.02 µm steps, and the line width was measured with attention paid to the resist pattern lines obtained with a design line width of 1 µm. As a result, the difference between the maximum and minimum widths attributable to the change in the thickness of the resist film was as large as 0.13 µm.

### Example 9

A silicon wafer was placed as a substrate into a reactor 1 kept at atmospheric pressure by nitrogen gas, and the substrate temperature was set at 20°C. Then, triethylamine gas was introduced as a catalyst into the reactor while bubbling in nitrogen gas. The flow rate of the mixed gas was 150 ml/min. In this state, the reaction mixture was allowed to stand for 1 minute, and the substrate was transferred into a reactor 2. The substrate temperature was set at 20°C again, the cyanoacetylene as a monomer gas was introduced into the reactor 2 with nitrogen gas as a carrier gas. The flow rate of the mixed monomer gas was 300 ml/min. While the reaction mixture was allowed to stand for 1 minute, the vapor phase polymerization reaction of cyanoacetylene occurred on the substrate, to form a thin cyanoacetylene polymer highly capable of covering steps on the silicon wafer. Subsequently, the substrate was placed into an oven of nitrogen gas atmosphere set at a temperature of 300°C for heat treatment for 30 minutes. Thus, a 0.1 µm thick cyanoacetylene polymer film was formed. The re'flectance (12° in the angle of incidence) of the substrate with the thin optical film formed was measured using a spectrophotometer produced by Hitachi, Ltd. (U-3410), and found to be about 5% in a range from 500 to 230 nm.

### Example 10

Fig. 1 is a schematic drawing showing an apparatus of the present invention viewed from above. In the drawing, transfer chambers (a) are provided to transfer a substrate between respective chambers. A load chamber (b) is provided to load a substrate into the apparatus. A reaction chamber 1 (c) is provided to cause a substrate on its surface to adsorb a catalyst gas. A reaction chamber 2 (d) is provided to cause a substrate on its surface to be in contact with a monomer gas. A heat treatment chamber (e) is provided to heat-treat a substrate. An unloading chamber (f) is provided to unload a substrate from the apparatus.

A silicon substrate was fed into the load chamber and transferred through a transfer chamber into the reaction chamber 1. Then, triethylamine as a catalyst and nitrogen gas were blown into the reaction chamber 1 at a rate of 100 ml/min with bubbling, for gasification, and the substrate was exposed for 100 seconds, to adsorb the catalyst on its surface. Subsequently, the silicon substrate with the catalyst adsorbed was transferred through a transfer chamber, into the reaction chamber 2. In the reaction chamber 2, it was brought into contact with cyanoacetylene as a monomer gas at 25°C for 40 seconds, to form a thin polymer film (about 150 nm thick) on the surface of the silicon substrate. The substrate was transferred through a transfer chamber into the heat treatment chamber, to be heat-treated (300°C). The heat-treated substrate was transferred through a transfer chamber into the unloading chamber, and the substrate with the desired thin polymer film formed was taken out of the unloading chamber.

As demonstrated above, a two-layer structure resist embodying the invention has incorporated in it a thin film excellent in light interceptability, reflection preventiveness and film uniformity to give a fine resist pattern stable in processability.

## Claims

1. Use, in the formation of a resist pattern on a substrate by photolithography, of a thin film, mainly composed of a conjugated polymer, as an antireflective coating, the said thin film serving as an antireflective coating during production, by photolithography, of a patterned resist containing the said thin film.

2. Use according to claim 1, wherein the patterned resist comprises the said thin film and a layer formed from a photosensitive composition and wherein the patterned resist is used as a mask during formation by lithography, of a resist pattern on a substrate.

3. Use according to claim 1 or claim 2, wherein the conjugated polymer is selected from polyacetylene, polypyrrole, polythiophene, polyphenylenevinylene, polythiophenevinylene and their derivatives.

4. Use according to claim 3, wherein the conjugated polymer is selected from polyacetylene and substituted polyacetylenes.

5. Use according to claim 4, wherein the substituted polyacetylenes are polycyanoacetylene, polymethylacetylene, polyphenylacetylene and polyfluoroacetylene.

6. Use according to any preceding claim, wherein the reflectance of the thin film to light is 30% or less.

7. Use according to any preceding claim, wherein a two-layer structure resist is prepared by a process comprising the steps of forming the thin film mainly composed of a conjugated polymer on a substrate; and subsequently forming on the said thin film a photosensitive resist layer to provide a photosensitive resist.

8. Use according to claim 7, wherein the said thin film is formed by vapor phase polymerization.

9. Use according to claim 7, wherein the said thin film is formed by applying a solution containing at least one polymer selected from conjugated polymers and their precursor products.

10. Use according to claim 7, wherein the said thin film is formed by polymerizing a monomer of the conjugated polymer on the substrate in the presence of a catalyst.

11. Use according to claim 7, wherein the said thin film is formed by plasma-polymerizing a monomer of the conjugated polymer.

12. Use according to claim 7, wherein the said thin film is formed by gasifying a catalyst, letting the gasified catalyst be adsorbed onto a surface of the substrate, and bringing it into contact with a monomer gas, for formation of the polymer on the surface of the substrate on which the catalyst is adsorbed.

13. Use according to claim 10 or 12, wherein the catalyst is an amine compound.

14. A method of forming on a substrate a patterned resist, which patterned resist comprises a two layer structure, which two layers are (1) a thin film mainly composed of a conjugated polymer and (2) a photosensitive resist layer respectively, which method comprises the steps of
(a) forming on the substrate the said thin film layer (1),
(b) forming on the said thin film layer (1) the photosensitive resist layer (2),
(c) exposing a selected part of the photosensitive resist layer (2) to UV light, leaving a part unexposed,
(d) removing unexposed part of the photosensitive resist layer (2) with a solvent, and
(e) removing part of the said thin film layer (1) thus exposed by etching.

15. A method according to claim 14, wherein the conjugated polymer of the thin film is selected from polyacetylene, polypyrrole, polythiophene, polyphenylenevinylene, polythiophenevinylene and their derivatives.

16. A method according to claim 15, wherein the conjugated polymer is selected from polyacetylene and substituted polyacetylenes.

17. A method according to claim 16, wherein the substituted polyacetylenes are polycyanoacetylene, polymethylacetylene, polyphenylacetylene and polyfluoroacetylene.

18. A method according to any one of claims 14 to 17, wherein the reflectance of the thin film to light is 30% or less.

19. A method according to any one of claims 14 to 18, wherein, in step (b), the said thin film is formed by vapor phase polymerization.

20. A method according to any one of claims 14 to 18, wherein, in step (b), the said thin film is formed by applying a solution containing at least one polymer selected from conjugated polymers and their precursor products.

21. A method according to claim 15, wherein the said thin film is formed by polymerizing a monomer of the conjugated polymer on the substrate in the presence of a catalyst.

22. A method according to claim 14, wherein the said thin film is formed by plasma-polymerizing a monomer of the conjugated polymer.

23. A method according to claim 14, wherein the said thin film is formed by gasifying a catalyst, letting the gasified catalyst be adsorbed onto a surface of the substrate, and bringing it into contact with a monomer gas, for formation of the polymer on the surface of the substrate on which the catalyst is adsorbed.

24. A method according to claim 21 or 23, wherein the catalyst is an amine compound.

## Patentansprüche

1. Verwendung eines hauptsächlich aus einem konjugierten Polymer bestehenden Dünnfilms als Antireflex-Beschichtung bei der Bildung eines Widerstands- bzw. Resistmusters auf einem Substrat mittels Photolithographie, wobei der Dünnfilm als Antireflex-Beschichtung während der mittels Photolithographie erfolgenden Herstellung eines gemusterten Resists dient, das den Dünnfilm enthält.

2. Verwendung nach Anspruch 1, worin das gemusterte Resist den Dünnfilm und eine Schicht umfasst, die von einer lichtempfindlichen Zusammensetzung gebildet wird, und worin während der Bildung eines Resistmusters auf dem Substrat mittels Lithographie das gemusterte Resist als Maske verwendet wird.

3. Verwendung nach Anspruch 1 oder 2, worin das konjugierte Polymer aus Polyacetylen, Polypyrrol, Polythiophen, Polyphenylenvinylen, Polythiophenvinylen und deren Derivaten ausgewählt ist.

4. Verwendung nach Anspruch 3, worin das konjugierte Polymer aus Polyacetylen und substituierten Polyacetylenen ausgewählt ist.

5. Verwendung nach Anspruch 4, worin die substituierten Polyacetylene Polycyanoacetylen, Polymethylacetylen, Polyphenylacetylen und Polyfluoracetylen sind.

6. Verwendung nach einem der vorangegangenen Ansprüche, worin das Lichtreflexionsvermögen des Dünnfilms 30% oder weniger beträgt.

7. Verwendung nach einem der vorangegangenen Ansprüche, worin eine zweischichtige Resiststruktur nach einem Verfahren hergestellt wird, das folgende Schritte umfasst: Ausbilden des hauptsächlich aus einem konjugierten Polymer bestehenden Dünnfilms auf einem Substrat; und anschließendes Ausbilden einer lichtempfindlichen Resistschicht auf dem Dünnfilm, um ein lichtempfindliches Resist zu bilden.

8. Verwendung nach Anspruch 7, worin der Dünnfilm durch Dampfphasen-Polymerisation gebildet wird.

9. Verwendung nach Anspruch 7, worin der Dünnfilm durch Aufbringen einer Lösung gebildet wird, die zumindest ein Polymer enthält, das aus konjugierten Polymeren und deren Vorläuferprodukten ausgewählt ist.

10. Verwendung nach Anspruch 7, worin der Dünnfilm durch Polymerisation eines Monomers des konjugierten Polymers auf dem Substrat in Gegenwart eines Katalysators gebildet wird.

11. Verwendung nach Anspruch 7, worin der Dünnfilm durch Plasma-Polymerisation eines Monomers des konjugierten Polymers gebildet wird.

12. Verwendung nach Anspruch 7, worin der Dünnfilm folgendermaßen gebildet wird: Überführen eines Katalysators in den gasförmigen Zustand, Adsorbieren-Lassen des gasförmigen Katalysators an eine Oberfläche des Substrats und In-Kontakt-Bringen desselben mit einem Monomergas zur Bildung des Polymers auf der Oberfläche des Substrats, an die der Katalysator adsorbiert ist.

13. Verwendung nach Anspruch 10 oder 12, worin der Katalysator eine Aminverbindung ist.

14. Verfahren zur Bildung eines gemusterten Resists auf einem Substrat, welches gemusterte Resist eine zweischichtige Struktur umfasst, welche zwei Schichten (1) ein hauptsächlich aus einem konjugierten Polymer bestehender Dünnfilm und (2) eine lichtempfindliche Resistschicht sind, welches Verfahren die folgenden Schritte umfasst:
(a) Ausbilden der Dünnfilmschicht (1) auf dem Substrat,
(b) Ausbilden der lichtempfindlichen Resistschicht (2) auf der Dünnfilmschicht (1),
(c) Bestrahlen eines ausgewählten Teils der lichtempfindlichen Resistschicht (2) mit UV-Licht, wobei ein Teil nicht bestrahlt wird,
(d) Entfernen des nicht bestrahlten Teils der lichtempfindlichen Resistschicht (2) mit einem Lösungsmittel, und
(e) Entfernen eines Teils der so bestrahlten Dünnfilmschicht (1) durch Ätzen.

15. Verfahren nach Anspruch 14, worin das konjugierte Polymer für den Dünnfilm aus Polyacetylen, Polypyrrol, Polythiophen, Polyphenylenvinylen, Polythiophenvinylen und deren Derivaten ausgewählt ist.

16. Verfahren nach Anspruch 15, worin das konjugierte Polymer aus Polyacetylen und substituierten Polyacetylenen ausgewählt ist.

17. Verfahren nach Anspruch 16, worin die substituierten Polyacetylene Poylcyanoacetylen, Polymethylacetylen, Polyphenylacetylen und Polyfluoracetylen sind.

18. Verfahren nach einem der Ansprüche 14 bis 17, worin das Lichtreflexionsvermögen des Dünnfilms 30% oder weniger beträgt.

19. Verfahren nach einem der Ansprüche 14 bis 18, worin in Schritt (b) der Dünnfilm durch Dampfphasen-Polymerisation gebildet wird.

20. Verfahren nach einem der Ansprüche 14 bis 18, worin in Schritt (b) der Dünnfilm durch Aufbringen einer Lösung gebildet wird, die zumindest ein Polymer enthält, das aus konjugierten Polymeren und deren Vorläuferprodukten ausgewählt ist.

21. Verfahren nach Anspruch 15, worin der Dünnfilm durch Polymerisation eines Monomers des konjugierten Polymers auf dem Substrat in Gegenwart eines Katalysators gebildet wird.

22. Verfahren nach Anspruch 14, worin der Dünnfilm durch Plasma-Polymerisation eines Monomers des konjugierten Polymers gebildet wird.

23. Verfahren nach Anspruch 14, worin der Dünnfilm folgendermaßen gebildet wird: Überführen eines Katalysators in den gasförmigen Zustand, Adsorbieren-Lassen des gasförmigen Katalysators an eine Oberfläche des Substrats und In-Kontakt-Bringen desselben mit einem Monomergas zur Bildung des Polymers auf der Oberfläche des Substrats, an die der Katalysator adsorbiert ist.

24. Verfahren nach Anspruch 21 oder 23, worin der Katalysator eine Aminverbindung ist.

## Revendications

1. Utilisation, dans la formation d'un motif de résist sur un substrat par photo-lithographie, d'un film fin, principalement composé d'un polymère conjugué, en tant que revêtement anti-réflecteur, ledit film fin servant en tant que revêtement anti-réflecteur pendant la production, par photo-lithographie, d'un résist mis en motif contenant ledit film fin.

2. Utilisation selon la revendication 1, dans laquelle le résist mis en motif comprend ledit film fin et une couche formée d'une composition photosensible et où le résist mis en motif est utilisé en tant que masque pendant la formation par lithographie, d'un motif de résist sur un substrat.

3. Utilisation selon la revendication 1 ou la revendication 2, dans laquelle le polymère conjugué est choisi parmi le polyacétylène, le polypyrrole, le polythiophène, le polyphénylènevinylène, le polythiophènevinylène et leurs dérivés.

4. Utilisation selon la revendication 3, dans laquelle le polymère conjugué est choisi parmi le polyacétylène et les polyacétylènes substitués.

5. Utilisation selon la revendication 4, dans laquelle les polyacétylènes substitués sont le polycyanoacétylène, le polyméthylacétylène, le polyphénylacétylène et le polyfluoroacétylène.

6. Utilisation selon l'une quelconque des revendications précédentes, dans laquelle la réflectance du film fin à la lumière est de 30% ou moins.

7. Utilisation selon l'une quelconque des revendications précédentes, dans laquelle un résist de structure à deux couches est préparé par un procédé comprenant les étapes de formation du film fin principalement composé d'un polymère conjugué sur un substrat ; et la formation ensuite sur ledit film fin d'une couche de résist photosensible pour fournir un résist photosensible.

8. Utilisation selon la revendication 7, dans laquelle ledit film fin est formé par polymérisation en phase vapeur.

9. Utilisation selon la revendication 7, dans laquelle ledit film fin est formé par application d'une solution contenant au moins un polymère choisi parmi les polymères conjugués et leurs produits précurseurs.

10. Utilisation selon la revendication 7, dans laquelle ledit film fin est formé par polymérisation d'un monomère du polymère conjugué sur le substrat en présence d'un catalyseur.

11. Utilisation selon la revendication 7, dans laquelle ledit film fin est formé par polymérisation par plasma du monomère du polymère conjugué.

12. Utilisation selon la revendication 7, dans laquelle ledit film fin est formé en gazéifiant un catalyseur, en laissant le catalyseur gazéifié être adsorbé sur une surface du substrat, et en l'amenant en contact avec un gaz monomère, pour la formation du polymère sur la surface du substrat sur laquelle le catalyseur est adsorbé.

13. Utilisation selon la revendication 10 ou la revendication 12, dans laquelle le catalyseur est un composé amine.

14. Méthode de formation sur un substrat d'un résist mis en motif, lequel résist mis en motif comprend une structure à deux couches, lesquelles deux couches sont (1) un film fin principalement composé d'un polymère conjugué et (2) une couche de résist photosensible respectivement, laquelle méthode comprend les étapes de
(a) formation sur le substrat de ladite couche de film fin (1),
(b) formation sur ladite couche de film fin (1) de la couche de résist photosensible (2),
(c) exposition d'une partie sélectionnée de la couche de résist photosensible (2) à une lumière UV, laissant une partie non exposée,
(d) élimination de la partie non exposée de la couche de résist photosensible (2) avec un solvant, et
(e) élimination de la partie de ladite couche de film fin (1) ainsi exposée par décapage.

15. Méthode selon la revendication 14, dans laquelle le polymère conjugué du film fin est choisi parmi le polyacétylène, le polypyrrole, le polythiophène, le polyphénylènevinylène, le polythiophènevinylène et leurs dérivés.

16. Méthode selon la revendication 15, dans laquelle le polymère conjugué est choisi parmi le polyacétylène et les polyacétylènes substitués.

17. Méthode selon la revendication 16, dans laquelle les polyacétylènes substitués sont le polycyanoacétylène, le polyméthylacétylène, le polyphénylacétylène et le polyfluoroacétylène.

18. Méthode selon l'une quelconque des revendications 14 à 17, dans laquelle la réflectance du film fin à une lumière est de 30% ou moins.

19. Méthode selon l'une quelconque des revendications 14 à 18, dans laquelle, dans l'étape (b) ledit film fin est formé par polymérisation en phase vapeur.

20. Méthode selon l'une quelconque des revendication 14 à 18, dans laquelle, dans l'étape (b), ledit film fin est formé par application d'une solution contenant au moins un polymère choisi parmi les polymères conjugués et leurs produits précurseurs.

21. Méthode selon la revendication 15, dans laquelle ledit film fin est formé par polymérisation d'un monomère du polymère conjugué sur le substrat en présence d'un catalyseur.

22. Méthode selon la revendication 14, dans laquelle ledit film fin est formé par polymérisation par plasma d'un monomère du polymère conjugué.

23. Méthode selon la revendication 14, dans laquelle ledit film fin est formé en gazéifiant un catalyseur, en laissant le catalyseur gazéifié être adsorbé sur une surface du substrat, et en l'amenant en contact avec un gaz monomère, pour la formation du polymère sur la surface du substrat sur laquelle le catalyseur est adsorbé.

24. Méthode selon la revendication 21 ou 23, dans laquelle le catalyseur est un composé amine.
